# DEMANDE DE BREVET EUROPEEN

(11) **EP 4 794 198 A1**
(43) Date de publication de la demande: **19.08.2026**
(21) Numéro de dépôt: 26156115.3
(22) Date de dépôt: 03.02.2026
(51) Int. Cl.: H03H 3/02, H03H 9/02, H03H 9/17, H03H 9/05

(54) **FILTRE A ONDES ACOUSTIQUES DE VOLUME**

(30) Priorité: 18.02.2025 FR 2501664
(71) Demandeur: STMicroelectronics International N.V., 1228 Plan-les-Ouates, Geneva (CH)
(72) Inventeur: BOUFNICHEL, Mohamed, 37380 MONNAIE (FR)
(74) Mandataire: Cabinet Beaumont

(57) **Abrégé**

La présente description concerne un procédé de fabrication d'un filtre (400) à ondes acoustiques de volume comprenant les étapes successives suivantes :
a) prévoir un substrat semiconducteur (103) ;
b) former des première (105C) et deuxième (405) cavités d'air enterrées dans le substrat semiconducteur (103), la première cavité d'air (105C) étant interposée entre la deuxième cavité d'air et une face (103T) supérieure du substrat semiconducteur (103) et présentant des dimensions latérales inférieures à celles de la deuxième cavité d'air ; et
c) amincir le substrat semiconducteur (103) par formation de tranchées (105P) entourant la première cavité d'air (105C) et débouchant dans la deuxième cavité d'air.

## Description

### Domaine technique

La présente description concerne de façon générale les dispositifs électroniques, plus particulièrement les filtres à ondes acoustiques de volume, ou filtres BAW (de l'anglais « Bulk Acoustic Wave »).

### Technique antérieure

De nombreux dispositifs électroniques comprennent au moins un filtre à ondes acoustiques de volume. De tels filtres sont par exemple intégrés dans des téléphones mobiles, ou smartphones, pour éviter que le fonctionnement d'un canal de réception de communications radiofréquence du téléphone ne soit perturbé par des interférences causées par des signaux radiofréquence émis par d'autres dispositifs électroniques, ou par du bruit électromagnétique provenant de sources radiofréquence externes.

Deux types de filtres à ondes acoustiques de volume ont déjà été proposés : les filtres dits « SMR » (de l'anglais « Solidly Mounted Resonator » - résonateur monté rigidement), d'une part, et les filtres dits « FBAR » (de l'anglais « thin-Film Bulk Acoustic Resonator » - résonateur acoustique en volume à film mince), également appelés filtres à ondes acoustiques de volume « à membrane », d'autre part. Un filtre SMR comprend typiquement une membrane en un matériau isolant, située sur et en contact mécanique avec un miroir de Bragg, et une couche piézoélectrique, située sur la membrane, interposée entre une électrode inférieure et une électrode supérieure. Les filtres FBAR diffèrent des filtres SMR principalement en ce que, dans le cas des filtres FBAR, le miroir de Bragg est substitué par une cavité d'air au-dessus de laquelle est suspendue la membrane. La présence de la cavité d'air confère aux filtres FBAR une meilleure efficacité que celle des filtres SMR. La cavité d'air procure en effet une isolation acoustique supérieure à celle obtenue par l'utilisation d'un miroir de Bragg présentant plusieurs bicouches (pour obtenir une isolation équivalente à celle d'une cavité d'air, il faudrait prévoir environ une quinzaine de bicouches, ce qui serait très difficile à réaliser en pratique), d'où il résulte une réduction de pertes énergétiques.

Toutefois, les filtres à ondes acoustiques existants, notamment les filtres FBAR existants, souffrent de divers inconvénients. En particulier, les filtres existants sont difficiles à miniaturiser. Dans les filtres existants, l'empilement comprenant l'électrode inférieure, la couche piézoélectrique et l'électrode supérieure est formé sur un substrat présentant une épaisseur de l'ordre de plusieurs centaines de micromètres. Afin de réduire les dimensions du filtre, le substrat est par exemple aminci par meulage depuis une face arrière du substrat, opposée à l'empilement. Cette étape d'amincissement ne permet toutefois pas d'atteindre des épaisseurs de substrat inférieures à environ une centaine de micromètres.

### Résumé de l'invention

Il existe un besoin de pallier tout ou partie des inconvénients des filtres à ondes acoustiques de volume existants, en particulier des filtres FBAR existants, et de leurs procédés de fabrication. Il serait notamment souhaitable de réduire les dimensions, en particulier l'épaisseur, des filtres existants.

Pour cela, un mode de réalisation prévoit un procédé de fabrication d'un filtre à ondes acoustiques de volume comprenant les étapes successives suivantes :
a) prévoir un substrat semiconducteur ;
b) former des première et deuxième cavités d'air enterrées dans le substrat semiconducteur, la première cavité d'air étant interposée entre la deuxième cavité d'air et une face supérieure du substrat semiconducteur et présentant des dimensions latérales inférieures à celles de la deuxième cavité d'air ; et
c) amincir le substrat semiconducteur par formation de tranchées entourant la première cavité d'air et débouchant dans la deuxième cavité d'air.

Selon un mode de réalisation, le procédé comprend en outre, entre les étapes a) et b), une étape de formation, dans le substrat semiconducteur, d'un premier ensemble de premiers vias et d'un deuxième ensemble de deuxièmes vias entourant le premier ensemble de premiers vias.

Selon un mode de réalisation, à l'étape b), la première cavité d'air est formée à partir des premiers vias et la deuxième cavité d'air est formée à partir des premiers et deuxièmes vias.

Selon un mode de réalisation, le procédé comprend, entre les étapes a) et b), les opérations suivantes :
- former les premiers et deuxièmes vias par gravure anisotrope du substrat semiconducteur ;
- former une première région partiellement sphérique au fond de chaque via par gravure isotrope du substrat semiconducteur ;
- prolonger les premiers et deuxièmes vias par gravure anisotrope du substrat semiconducteur ; et
- former une deuxième région partiellement sphérique au fond de chaque via par gravure isotrope du substrat semiconducteur.

Selon un mode de réalisation, le procédé comprend, entre les étapes a) et b), les opérations suivantes :
- former les premiers et deuxièmes vias par gravure anisotrope du substrat semiconducteur ; et
- former une région partiellement sphérique au fond de chaque deuxième via par gravure isotrope du substrat semiconducteur.

Selon un mode de réalisation, le procédé comprend, entre les étapes a) et b), les opérations suivantes :
- former les premiers vias par gravure anisotrope du substrat semiconducteur ;
- former une première région partiellement sphérique au fond de chaque premier via par gravure isotrope du substrat semiconducteur ;
- prolonger les premiers vias par gravure anisotrope du substrat semiconducteur ;
- former une deuxième région partiellement sphérique au fond de chaque premier via par gravure isotrope du substrat semiconducteur ;
- former les deuxièmes vias par gravure anisotrope du substrat semiconducteur ; et
- former une troisième région partiellement sphérique au fond de chaque deuxième via par gravure isotrope du substrat semiconducteur.

Selon un mode de réalisation, le procédé comprend en outre, à l'étape b), la formation, à partir de chacun des premier et deuxième vias, d'au moins une troisième cavité d'air interposée entre les première et deuxième cavités d'air.

Selon un mode de réalisation, le procédé comprend en outre, à l'étape b), la formation, à partir de chaque deuxième via, d'au moins une quatrième cavité d'air située, dans le substrat semiconducteur, à une profondeur sensiblement égale à celle de la première cavité d'air.

Selon un mode de réalisation, le procédé comprend en outre, entre les étapes b) et c), une étape de réalisation d'au moins un résonateur à l'aplomb de la première cavité d'air, chaque résonateur comprenant une couche active interposée entre une électrode inférieure et une électrode supérieure.

Selon un mode de réalisation, à l'étape b), la première cavité d'air et la deuxième cavité d'air sont formées par recuit du substrat semiconducteur sous atmosphère d'hydrogène.

Un mode de réalisation prévoit un filtre à ondes acoustiques de volume obtenu par le procédé tel que décrit.

Selon un mode de réalisation, la première cavité d'air est située, dans le substrat semiconducteur, à une profondeur comprise entre 300 nm et 1,5 µm.

Selon un mode de réalisation, le substrat semiconducteur présente, après amincissement, une épaisseur inférieure à 50 µm, de préférence inférieure à 25 µm, plus préférentiellement inférieure à 10 µm.

Un mode de réalisation prévoit un dispositif électronique, de préférence un téléphone mobile ou un smartphone, comprenant un circuit intégré radiofréquence comportant au moins un filtre tel que décrit.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 illustre, par des vues de côté et en coupe, schématiques et partielles, des étapes d'un exemple de procédé de formation de cavités dans un substrat selon un mode de réalisation ;
la figure 2 illustre, par des vues de côté et en coupe, schématiques et partielles, des étapes d'un exemple de procédé de formation de cavités dans un substrat selon un mode de réalisation ;
la figure 3 illustre, par des vues de côté et en coupe, schématiques et partielles, des étapes successives d'un exemple de procédé de formation de cavités dans un substrat selon un mode de réalisation ;
la figure 4A, la figure 4B, la figure 4C, la figure 4D, la figure 4E, la figure 4F, la figure 4G, la figure 4H, la figure 4I et la figure 4J illustrent, de façon schématique et partielle, des étapes successives d'un exemple de procédé de fabrication d'un filtre à ondes acoustiques de volume selon un mode de réalisation ;
la figure 5A et la figure 5B illustrent, par des vues de côté et en coupe, schématiques et partielles, des étapes successives d'une variante du procédé des figures 4A à 4J ;
la figure 6A, la figure 6B et la figure 6C illustrent, par des vues de côté et en coupe, schématiques et partielles, des étapes successives d'une variante du procédé des figures 4A à 4J ;
la figure 7A et la figure 7B illustrent, par des vues de côté et en coupe, schématiques et partielles, des étapes successives d'une variante du procédé des figures 4A à 4J ;
la figure 8 est une vue de côté et en coupe, schématique et partielle, d'un exemple de filtre à ondes acoustiques de volume selon un mode de réalisation ; et
la figure 9 illustre, de façon schématique et partielle, un exemple de dispositif électronique intégrant un filtre à ondes acoustiques de volume.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, l'intégration des filtres à ondes acoustiques de volume dans les différents dispositifs électroniques susceptibles de mettre en œuvre de tels filtres n'a pas été détaillée, les modes de réalisation décrits étant compatibles avec tous ou la plupart des dispositifs électroniques intégrant au moins un filtre, moyennant éventuellement des adaptations à la portée de la personne du métier à la lecture de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % ou à 10° près, de préférence à 5 % ou à 5° près.

Sauf précision contraire, les termes « isolant » et « conducteur » signifient respectivement électriquement isolant et électriquement conducteur.

Sauf précision contraire, l'expression « en contact avec » signifie « en contact mécanique avec ».

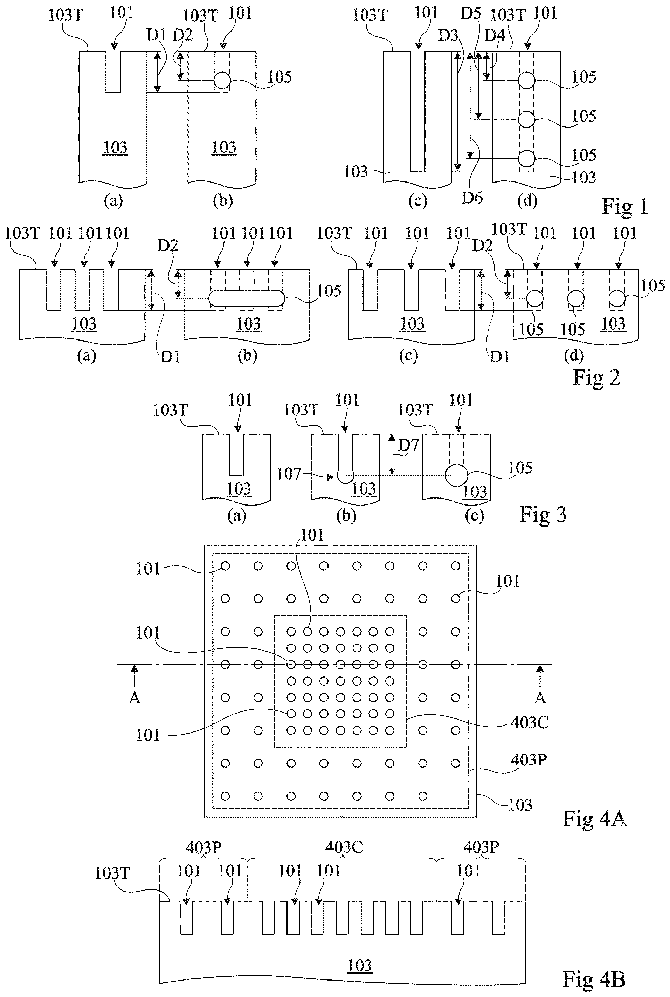

La figure 1 illustre, par des vues de côté et en coupe, schématiques et partielles, des étapes d'un exemple de procédé de formation de cavités dans un substrat selon un mode de réalisation.

La figure 1 comporte une vue (a) représentant de façon très schématique une structure obtenue à l'issue d'une étape de formation d'un via 101 dans un substrat semiconducteur 103.

À titre d'exemple, le substrat semiconducteur 103 est une plaquette ou un morceau de plaquette en un matériau semiconducteur, par exemple le silicium.

Dans l'exemple illustré, le via 101 s'étend depuis une face supérieure 103T du substrat semiconducteur 103 jusqu'à une profondeur D1 inférieure à l'épaisseur du substrat 103. Dans cet exemple, le via 101 est borgne, c'est-à-dire qu'il ne débouche pas du côté d'une face inférieure du substrat 103 opposée à la face supérieure 103T.

Le via 101 présente par exemple, en vue de dessus, une section de forme sensiblement carrée. Cet exemple n'est toutefois pas limitatif, le via 101 pouvant plus généralement présenter, en vue de dessus, une forme quelconque, par exemple une forme polygonale autre que carrée - par exemple rectangulaire, triangulaire, hexagonale, etc. - ou une forme arrondie - par exemple ovale, circulaire, etc.

Le via 101 est par exemple réalisé par photolithographie puis gravure. Pour cela, une couche de résine photosensible (non représentée) est par exemple déposée du côté de la face supérieure 103T du substrat semiconducteur 103. La couche de résine photosensible revêt par exemple toute la face supérieure 103T du substrat semiconducteur 103, la couche de résine photosensible étant par exemple plus précisément située sur et en contact avec la face supérieure 103T du substrat semiconducteur 103.

Une ouverture traversante est par exemple ensuite formée dans la couche de résine photosensible à l'emplacement désiré du futur via 101, par exemple par insolation de la couche de résine photosensible à travers un masque et retrait de parties insolées de la couche de résine photosensible, dans le cas d'une résine positive, ou de parties non insolées de la couche de résine photosensible, dans le cas d'une résine négative. Puis, l'ouverture est par exemple prolongée dans le substrat semiconducteur 103 par gravure, par exemple par gravure anisotrope de type gravure ionique réactive (« Reactive Ion Etching » - RIE, en anglais), par exemple par gravure ionique réactive dite profonde (« Deep Reactive Ion Etching » - DRIE, en anglais).

La couche de résine photosensible est par exemple ensuite intégralement retirée.

Dans l'exemple représenté, le fond du via 101 est situé à la profondeur D1, c'est-à-dire que le fond du via 101 est séparé de la face supérieure 103T du substrat semiconducteur 103 par une distance D1.

La figure 1 comporte en outre une vue (b) représentant de façon très schématique une structure obtenue, à partir de la structure de la vue (a), à l'issue d'une étape ultérieure de recuit du substrat semiconducteur 103 dans lequel a préalablement été formé le via 101.

Dans l'exemple illustré, le recuit conduit à la formation d'une cavité 105 à partir du via 101. Le recuit est par exemple effectué à une température de l'ordre de 1 000 °C, par exemple comprise entre 1 000 °C et 1 150 °C. Le recuit est par exemple en outre effectué sous atmosphère d'hydrogène, dans le cas où le substrat semiconducteur 103 est en silicium. Le fait de recuire sous hydrogène permet aux atomes de silicium du substrat semiconducteur 103 de présenter une mobilité de surface plus importante qu'en l'absence d'hydrogène.

Sous l'action du recuit, les atomes de silicium du substrat semiconducteur 103 se réorganisent de sorte que la structure présente une rugosité de surface et une énergie de surface minimales sans perte de volume. En pratique, le via 101 tend à s'évaser en partie inférieure, c'est-à-dire au voisinage de son fond, et à s'obturer en partie supérieure, c'est-à-dire au voisinage de la face supérieure 103T du substrat semiconducteur 103. Du fait de ces phénomènes, le via 101 se transforme progressivement en la cavité 105. Le fond de la cavité 105 est situé, dans le substrat semiconducteur 103, à une profondeur D2 strictement inférieure à la profondeur D1 du via 101.

La figure 1 comporte en outre une vue (c) représentant de façon très schématique une variante de la structure de la vue (a).

Dans la structure de la vue (c), le via 101 présente une profondeur D3 strictement supérieure, par exemple environ trois fois supérieure, à la profondeur D1 du via 101 de la structure de la vue (a). Le via 101 de la vue (c) est par exemple obtenu en mettant en œuvre une étape de gravure plus longue que celle permettant de réaliser le via 101 de la vue (a).

La figure 1 comporte en outre une vue (d) représentant de façon très schématique une structure obtenue, à partir de la structure de la vue (c), à l'issue d'une étape ultérieure de recuit du substrat semiconducteur 103 dans lequel a préalablement été formé le via 101. L'étape de recuit est par exemple mise en œuvre de façon analogue à ce qui a été décrit ci-dessus en relation avec la vue (b).

Dans l'exemple illustré, le recuit conduit, à partir du via 101, à la formation de trois cavités 105 sensiblement alignées verticalement. Les fonds des cavités 105 sont, de la cavité 105 la moins profonde à la cavité 105 la plus profonde, respectivement situés à des profondeurs D4, D5 et D6 différentes dans le substrat semiconducteur 103. Dans l'exemple représenté, la profondeur D6 à laquelle est situé le fond de la cavité 105 la plus profonde est strictement inférieure à la profondeur D3 à laquelle est situé le fond du via 101. Par ailleurs, la profondeur D4 à laquelle est situé le fond de la cavité 105 la moins profonde est par exemple sensiblement égale à la profondeur D2.

Lors du recuit, le via 101 se referme progressivement en partant du bas. Dans cet exemple, les cavités 105 sont successivement formées, de la plus profonde à la moins profonde, à mesure que le via 101 se referme sous l'action du recuit.

Comme illustré en figure 1, il est donc possible de former, à partir d'un même via 101, une ou plusieurs cavités 105 disjointes dans l'épaisseur du substrat semiconducteur 103 selon que le via 101 est plus ou moins profond. Bien que les vues (c) et (d) illustrent un cas dans lequel trois cavités 105 sont formées à partir du via 101 de profondeur D3, cet exemple n'est pas limitatif et la personne du métier est capable, à titre de variante, d'ajuster la profondeur du via 101 en fonction du nombre de cavités 105 qu'elle souhaite obtenir après recuit.

La figure 2 illustre, par des vues de côté et en coupe, schématiques et partielles, des étapes d'un exemple de procédé de formation de cavités dans un substrat selon un mode de réalisation.

La figure 2 comporte une vue (a) représentant de façon très schématique une structure obtenue à l'issue d'une étape de formation d'une pluralité de vias 101 dans le substrat semiconducteur 103.

Les vias 101 sont par exemple agencés en réseau selon des lignes et des colonnes, les lignes étant par exemple sensiblement perpendiculaires aux colonnes. Le réseau formé par les vias 101 présente par exemple, aux dispersions de fabrication près, un pas sensiblement constant, c'est-à-dire une distance centre-à-centre entre deux vias 101 voisins sensiblement constante.

À titre d'exemple, les vias 101 présentent des formes et des dimensions sensiblement identiques, aux dispersions de fabrication près. Les vias 101 présentent par exemple notamment une même profondeur, par exemple la profondeur D1, aux dispersions de fabrication près.

La figure 2 comporte en outre une vue (b) représentant de façon très schématique une structure obtenue, à partir de la structure de la vue (a), à l'issue d'une étape ultérieure de recuit du substrat semiconducteur 103 dans lequel ont préalablement été formés les vias 101.

Dans l'exemple illustré, le recuit conduit à la formation d'une unique cavité 105 à partir des vias 101. Le fond de la cavité 105 est par exemple situé à la profondeur D2.

La figure 2 comporte en outre une vue (c) représentant de façon très schématique une variante de la structure de la vue (a).

Dans la structure de la vue (c), les vias 101 sont agencés en un réseau présentant un pas strictement supérieur, par exemple une fois et demie supérieur, au pas du réseau formé par les vias 101 de la structure de la vue (a). Les vias 101 de la vue (c) sont par exemple obtenus en mettant en œuvre une étape de photolithographie à l'aide d'un masque présentant des ouvertures plus espacées les unes des autres que celles permettant de réaliser les vias 101 de la vue (a), suivie d'une étape de gravure.

La figure 2 comporte en outre une vue (d) représentant de façon très schématique une structure obtenue, à partir de la structure de la vue (c), à l'issue d'une étape ultérieure de recuit du substrat semiconducteur 103 dans lequel ont préalablement été formés les via 101. L'étape de recuit est par exemple mise en œuvre de façon analogue à ce qui a été décrit ci-dessus en relation avec la vue (b).

Dans l'exemple illustré, le recuit conduit, à partir des vias 101, à la formation de plusieurs cavités 105 (trois cavités 105, dans l'exemple représenté) sensiblement alignées horizontalement. Dans cet exemple, les fonds des cavités 105 sont situés à des profondeurs sensiblement identiques, par exemple sensiblement égales à la profondeur D2, dans le substrat semiconducteur 103.

Lors du recuit, les vias 101 se referment progressivement en formant des cavités 105 disjointes.

Comme illustré en figure 2, il est donc possible de former, à partir de plusieurs vias 101, une ou plusieurs cavités 105 disjointes dans l'épaisseur du substrat semiconducteur 103 selon que les vias 101 sont proches ou éloignés les uns des autres. Bien que les vues (c) et (d) illustrent un cas dans lequel trois cavités 105 sont formées à partir de trois vias 101, cet exemple n'est pas limitatif et la personne du métier est capable, à titre de variante, d'ajuster le nombre de vias 101 et l'espacement entre les vias 101 en fonction du nombre de cavités 105 qu'elle souhaite obtenir après recuit. À titre d'exemple, il existe un seuil de distance entre deux vias 101 voisins, de profondeurs sensiblement identiques, en-dessous duquel les deux vias 101 forment, après recuit, une unique cavité 105 et au-dessus duquel le recuit conduit à l'obtention de deux cavités 105 disjointes.

À titre d'exemple, la personne du métier pourra, pour la réalisation des étapes exposées ci-dessus en relation avec les figures 1 et 2, s'inspirer de ce qui est décrit dans la publication de I. Mizushima et al. intitulée « Empty-space-in-silicon technique for fabricating a silicon-on-nothing structure » parue en novembre 2000 dans la revue Applied Physics Letters.

La figure 3 illustre, par des vues de côté et en coupe, schématiques et partielles, des étapes successives d'un exemple de procédé de formation de cavités dans un substrat selon un mode de réalisation.

La figure 3 comporte une vue (a) représentant de façon très schématique une structure obtenue à l'issue d'une étape de formation d'un via 101 dans le substrat semiconducteur 103.

L'étape de formation du via 101 est par exemple mise en œuvre de façon analogue ou identique à ce qui a été décrit ci-dessus en relation avec la vue (a) de la figure 1.

La figure 3 comporte en outre une vue (b) représentant de façon très schématique une structure obtenue, à partir de la structure de la vue (a), à l'issue d'une étape ultérieure de gravure isotrope du via 101 préalablement formé dans le substrat semiconducteur 103.

À titre d'exemple, la gravure isotrope est mise en œuvre par exposition de la structure à de l'hexafluorure de soufre (SF₆).

Dans l'exemple représenté, la gravure isotrope conduit à la formation d'une région 107 partiellement sphérique au fond du via 101. Cela provient par exemple du fait que l'étape préalable de formation du via 101 conduit à passiver ses flancs, mais pas son fond. Il en résulte que l'étape de gravure isotrope agit exclusivement, ou principalement, en partie inférieure du via 101, c'est-à-dire au niveau du fond du via 101.

La figure 3 comporte en outre une vue (c) représentant de façon très schématique une structure obtenue, à partir de la structure de la vue (b), à l'issue d'une étape ultérieure de recuit du substrat semiconducteur 103 dans lequel a préalablement été formé le via 101.

L'étape de recuit est par exemple mise en œuvre de façon analogue ou identique à ce qui a été décrit ci-dessus en relation avec la vue (b) de la figure 1.

Dans l'exemple illustré, le recuit conduit à la formation d'une cavité 105 à partir du via 101. Dans cet exemple, le centre de la cavité 105 est situé, dans le substrat semiconducteur 103, à une profondeur D7 sensiblement égale à celle du centre de la région 107 de forme partiellement sphérique obtenue lors de l'étape précédente de gravure isotrope. Par ailleurs, la cavité 105 obtenue, après recuit, à partir du via 101 ayant subi l'étape de gravure isotrope présente un volume strictement supérieur à celui de la cavité 105 obtenue, après recuit, à partir du via 101 n'ayant pas subi l'étape de gravure isotrope (par exemple la cavité 105 de la vue (b) de la figure 1).

Comme illustré en figure 3, il est donc possible de fixer ou de figer, par gravure isotrope du via 101, l'emplacement de la cavité 105 obtenue après l'étape ultérieure de recuit. La gravure isotrope permet en outre d'augmenter le volume de la cavité 105 obtenue à l'issue du recuit.

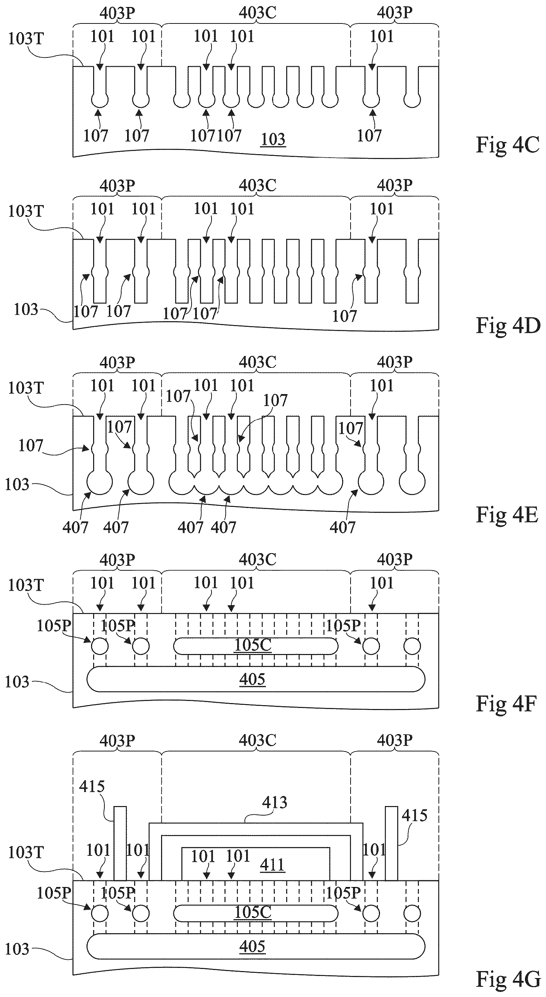

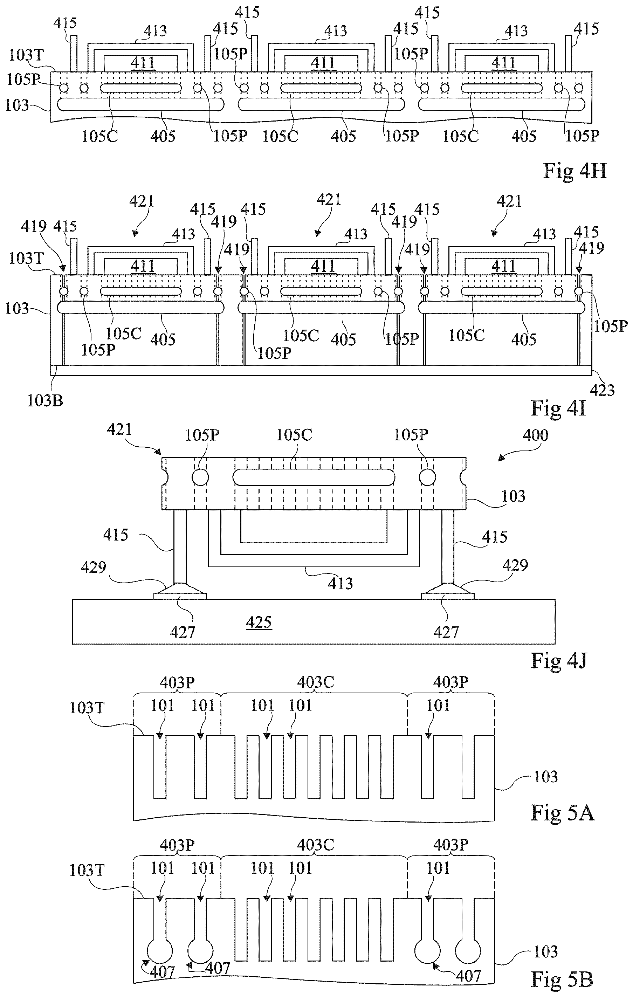

La figure 4A, la figure 4B, la figure 4C, la figure 4D, la figure 4E, la figure 4F, la figure 4G, la figure 4H, la figure 4I et la figure 4J illustrent, de façon schématique et partielle, des étapes successives d'un exemple de procédé de fabrication d'un filtre 400 à ondes acoustiques de volume selon un mode de réalisation.

La figure 4A est une vue de dessus, schématique et partielle, illustrant une étape de formation d'une pluralité de vias 101 dans le substrat semiconducteur 103. La figure 4B est une vue de côté et en coupe selon le plan AA de la figure 4A.

Dans l'exemple illustré, les vias 101 présentent des formes et des dimensions sensiblement identiques, aux dispersions de fabrication près. Les vias 101 présentent par exemple notamment une même profondeur, aux dispersions de fabrication près. À titre d'exemple, le fond de chaque via 101 de la structure de la figure 4A est situé sensiblement à la profondeur D1.

Dans l'exemple représenté, la structure comprend un premier ensemble 403C, ou ensemble 403C central, de vias 101 et un deuxième ensemble 403P, ou ensemble 403P périphérique, de vias 101 entourant le premier ensemble 403C de vias 101. Dans l'exemple illustré, les vias 101 faisant partie de l'ensemble central 403C sont agencés en réseau. En outre, dans cet exemple, les vias 101 faisant partie de l'ensemble périphérique 403P sont agencés en réseau. Dans l'exemple représenté, le réseau formé par les vias 101 de l'ensemble périphérique 403P présente un pas strictement supérieur au pas du réseau formé par les vias 101 de l'ensemble central 403C.

Le pas du réseau formé par les vias 101 de l'ensemble central 403C et le pas du réseau formé par les vias 101 de l'ensemble périphérique 403P sont par exemple supérieurs au seuil de distance entre deux vias 101 voisins à partir duquel une étape ultérieure de recuit conduit à l'obtention de deux cavités 105 disjointes.

L'étape de formation des vias 101 est par exemple mise en œuvre de façon analogue ou identique à ce qui a été décrit ci-dessus en relation avec la vue (a) de la figure 1. En particulier, les vias 101 sont par exemple formés par photolithographie puis gravure anisotrope, par exemple de type RIE ou DRIE.

La figure 4C est une vue de côté et en coupe, schématique et partielle, illustrant une étape ultérieure de gravure isotrope des vias 101.

De manière analogue à ce qui a été précédemment décrit en relation avec la vue (b) de la figure 3, la gravure isotrope conduit, dans l'exemple représenté, à la formation de la région 107 partiellement sphérique au fond de chaque via 101. Dans l'exemple illustré, les régions 107 sont sensiblement situées à une même profondeur dans le substrat semiconducteur 103.

La figure 4D est une vue de côté et en coupe, schématique et partielle, illustrant une étape ultérieure de gravure anisotrope des vias 101.

Dans l'exemple illustré, les vias 101 sont prolongés dans le substrat semiconducteur 103, par exemple par photolithographie puis gravure. À titre d'exemple, le même masque de gravure que celui qui a servi à la formation des vias 101 lors de l'étape précédemment décrite en relation avec les figures 4A et 4B peut être utilisé pour prolonger les vias 101. La gravure est par exemple analogue ou identique à celle décrite ci-dessus en relation avec la vue (a) de la figure 1.

À l'issue de cette étape, chaque via 101 présente une profondeur strictement supérieure à la profondeur D1, par exemple égale à environ deux fois la profondeur D1.

La figure 4E est une vue de côté et en coupe, schématique et partielle, illustrant une étape ultérieure de gravure isotrope des vias 101.

De manière analogue à ce qui a été précédemment décrit en relation avec la figure 4C, la gravure isotrope conduit, dans l'exemple représenté, à la formation d'une région 407 partiellement sphérique au fond de chaque via 101. Dans l'exemple représenté, chaque région 107 préalablement formée lors de l'étape décrite ci-dessus en relation avec la figure 4C est interposée entre la face supérieure 103T du substrat semiconducteur 103 et la région 407 située au fond de chaque via 101. Dans l'exemple illustré, les régions 407 situées au fond de chaque via 101 sont sensiblement situées à une même profondeur dans le substrat semiconducteur 103.

Les régions 407 présentent par exemple des dimensions latérales - par exemple un diamètre, dans le cas où les régions 407 sont de forme sensiblement sphérique - strictement supérieures à celles des régions 107. À titre d'exemple, les régions 407 sont obtenues en mettant en œuvre une étape de gravure plus longue que celle permettant de réaliser les régions 107. La réalisation des régions 407 ne modifie pas sensiblement les dimensions des régions 107. Cela provient par exemple du fait que l'étape préalable de prolongation des vias 101 conduit à passiver leurs flancs, y compris les régions 107, mais pas leurs fonds.

La figure 4F est une vue de côté et en coupe, schématique et partielle, illustrant une étape ultérieure de recuit du substrat semiconducteur 103.

L'étape de recuit est par exemple mise en œuvre de façon analogue ou identique à ce qui a été décrit ci-dessus en relation avec la vue (b) de la figure 1.

Dans l'exemple illustré, le recuit conduit à l'obtention, à partir des régions 107 des vias 101 faisant partie de l'ensemble central 403C, d'une unique cavité 105C et, à partir des régions 107 des vias 101 faisant partie de l'ensemble périphérique 403P, de plusieurs cavités 105P disjointes. En outre, dans cet exemple, le recuit conduit à l'obtention, à partir des régions 407, d'une unique cavité 405. La cavité 405 est plus précisément formée à partir des régions 407 des vias 101 faisant partie de l'ensemble central 403C et à partir des régions 407 des vias 101 faisant partie de l'ensemble périphérique 403P. Dans l'exemple représenté, les cavités 105C et 405 sont superposées, la cavité 405 étant située à l'aplomb de la cavité 105C et présentant des dimensions latérales strictement supérieures à celles de la cavité 105C.

Chacune des cavités 105C, 105P, 405 est par exemple une cavité d'air enterrée, ou enfouie, dans le substrat semiconducteur 103. Chaque cavité 105C, 105P, 405 est ainsi intégralement contenue dans le substrat semiconducteur 103, chaque cavité étant totalement close.

Dans l'exemple illustré, chaque cavité 105C, 105P, 405 est entièrement bordée par le matériau du substrat semiconducteur 103. Chaque cavité 105C, 105P est, dans cet exemple, séparée de la face supérieure 103T du substrat semiconducteur 103 par une partie du substrat semiconducteur 103. Chaque cavité 105C, 105P est par exemple située à une profondeur comprise entre quelques centaines de nanomètres et quelques micromètres sous la face supérieure 103T du substrat semiconducteur 103. En d'autres termes, la face supérieure de chaque cavité 105C, 105P est séparée de la face supérieure du substrat semiconducteur 103 par une partie du substrat 103 présentant par exemple une épaisseur comprise entre quelques centaines de nanomètres et quelques micromètres. L'épaisseur de la partie du substrat 103 interposée entre la face supérieure de chaque cavité 105C, 105P et la face supérieure 103T du substrat 103 est par exemple plus précisément comprise entre 300 nm et 1,5 µm.

Dans cet exemple, la cavité 405 est séparée des cavités 105C et 105P par une partie du substrat semiconducteur 103. La cavité 405 est par exemple située à une profondeur sensiblement égale au double de la profondeur où se situent les cavités 105C et 105P.

Dans l'exemple représenté, les cavités 105C et 405 comprennent chacune des flancs arrondis, ou courbes, par exemple des flancs présentant une forme concave. À titre d'exemple, chaque flanc de la cavité 105C, 405 présente, en vue en coupe, une forme d'arc de cercle, par exemple de demi-cercle. Dans l'exemple représenté, chaque cavité 105P présente une forme sensiblement sphérique.

Chaque cavité 105C, 405 présente par exemple, en vue de dessus, une forme rectangulaire. Cet exemple n'est toutefois pas limitatif, chaque cavité 105C, 405 pouvant plus généralement présenter, en vue de dessus, une forme quelconque, par exemple une forme polygonale autre que rectangulaire - par exemple carrée, triangulaire, hexagonale, etc. - ou une forme arrondie - par exemple ovale, circulaire, etc.

La figure 4G est une vue de côté et en coupe, schématique et partielle, illustrant une étape ultérieure de formation, sur la face 103T du substrat semiconducteur 103, d'un résonateur 411, d'un capot 413 de protection du résonateur 411 et de deux piliers 415 conducteurs.

Dans l'exemple représenté, le résonateur 411 est situé sur et en contact avec la face supérieure 103T du substrat semiconducteur 103. Le résonateur 411 est situé à l'aplomb de la cavité 105C préalablement formée à partir des cavités 107 des vias 101 de l'ensemble central 403C. Dans cet exemple, le résonateur 411 ne s'étend pas latéralement à l'aplomb des cavités 105P préalablement formées à partir des cavités 107 des vias 101 de l'ensemble périphérique 403P.

Dans l'exemple illustré, le capot 413 de protection est situé en appui sur la face supérieure 103T du substrat semiconducteur 103 et entoure le résonateur 411.

Dans l'exemple représenté, les piliers 415 conducteurs sont situés de part et d'autre du capot 413. Chaque pilier 415 est par exemple en appui sur une partie de la face supérieure 103T du substrat semiconducteur 103 surplombant les cavités 105P.

La figure 4H est une vue d'ensemble du substrat semiconducteur 103 dans et sur lequel ont été réalisées plusieurs structures (trois structures, dans l'exemple représenté) identiques ou analogues à celle de la figure 4G.

La figure 4I est une vue de côté et en coupe, schématique et partielle, illustrant une étape ultérieure de formation de tranchées 419 délimitant latéralement une pluralité de puces semiconductrices 421.

Dans l'exemple représenté, les tranchées 419 s'étendent verticalement dans toute l'épaisseur du substrat semiconducteur 103, depuis sa face supérieure 103T jusqu'à sa face inférieure 103B. Les tranchées 419 peuvent être formées par gravure plasma, par sciage, ou par toute autre méthode de découpe adaptée.

Dans l'exemple illustré, un substrat 423 de support temporaire, par exemple un film, est utilisé pour maintenir mécaniquement les puces 421 lors et à l'issue de l'étape de découpe.

Chaque tranchée 419 entoure latéralement l'une des puces semiconductrices 421. En vue de dessus, chaque tranchée présente par exemple une forme rectangulaire, carrée, etc. Chaque tranchée 419 entoure latéralement la cavité 105C de la puce semiconductrice 421. Les tranchées 419 sont réalisées de sorte à déboucher dans la cavité 405. Cela conduit, pour chaque puce semiconductrice 421, à libérer une partie du substrat semiconducteur 103 interposée entre la cavité 405 et le résonateur 411 sus-jacent. Le substrat semiconducteur 103 est ainsi aminci, chaque puce semiconductrice 421 comprenant une portion de substrat semiconducteur 103 présentant une épaisseur sensiblement égale à la profondeur de la cavité 405, par exemple une épaisseur de l'ordre de quelques micromètres, par exemple comprise entre 3 et 5 µm.

La figure 4J est une vue de côté et en coupe, schématique et partielle, illustrant une étape ultérieure de fixation de l'une des puces semiconductrices 421 sur la face supérieure d'un substrat de report 425.

Au cours de cette étape, l'une des puces semiconductrices 421 de la figure 4I est par exemple retournée de façon à placer les piliers conducteurs 415 de la puce 421 en vis-à-vis de plots métalliques de connexion 427 correspondants du substrat de report 425. Les piliers conducteurs 415 et les plots 427 en vis-à-vis sont ensuite fixés et connectés électriquement, par exemple par soudure, au moyen de microtubes, ou par toute autre méthode adaptée. Dans l'exemple représenté, des billes de soudure 429 sont utilisées pour connecter électriquement et assembler mécaniquement les piliers 415 aux plots 427.

À l'issue des étapes décrites ci-dessus en relation avec les figures 4A à 4J, le filtre 400 à ondes acoustiques de volume est obtenu.

Selon un mode de réalisation, le filtre 400 comprend :
- la cavité d'air 105C enterrée dans le substrat semiconducteur 103 ;
- le résonateur 411 situé à l'aplomb de la cavité d'air 105C ; et
- plusieurs cavités d'air 105P enterrées dans le substrat semiconducteur 103 et situées au voisinage de la cavité d'air 105C.

Bien que les figures 4A à 4J prennent pour exemple un cas dans lequel un seul résonateur 411 est situé à l'aplomb de la cavité d'air 105C, cet exemple n'est pas limitatif et la personne du métier est capable, à partir des indications de la présente description, de prévoir que plusieurs résonateurs identiques ou analogues au résonateur 411 soient situés à l'aplomb de la cavité 105C. Par ailleurs, bien que la figure 4J prenne pour exemple un cas dans lequel le filtre 400 comprend plusieurs cavités 105P, cet exemple n'est pas limitatif, le filtre 400 pouvant, à titre de variante, comprendre une unique cavité 105P, par exemple une cavité 105P de forme annulaire entourant latéralement la cavité 105C, ou être dépourvu de cavités 105P.

Par ailleurs, bien que les figures 4A à 4E illustrent un cas dans lequel les différentes étapes de gravure des vias 101 faisant partie de l'ensemble 403C et des vias 101 faisant partie de l'ensemble 403P sont effectuées simultanément, cet exemple n'est pas limitatif et les différentes étapes de gravure des vias 101 peuvent être réalisées successivement pour les ensembles 403C et 403P.

La figure 5A et la figure 5B illustrent, par des vues de côté et en coupe, schématiques et partielles, des étapes successives d'une variante du procédé des figures 4A à 4J.

La figure 5A est une vue de côté et en coupe, schématique et partielle, illustrant une étape de formation d'une pluralité de vias 101 dans le substrat semiconducteur 103.

Dans l'exemple illustré, les vias 101 présentent des formes et des dimensions sensiblement identiques, aux dispersions de fabrication près. Les vias 101 présentent par exemple notamment une même profondeur, aux dispersions de fabrication près. À titre d'exemple, la structure de la figure 5A diffère de celle des figures 4A et 4B en ce que les vias 101 de la structure de la figure 5A présentent une profondeur supérieure à celle des vias 101 de la structure des figures 4A et 4B. À titre d'exemple, le fond de chaque via 101 de la structure de la figure 5A est situé à une profondeur comprise entre la profondeur D1 et la profondeur D3, par exemple à une profondeur permettant, après recuit, de former deux cavités à partir de chaque via 101.

La figure 5B est une vue de côté et en coupe, schématique et partielle, illustrant une étape ultérieure de gravure isotrope des vias 101 faisant partie de l'ensemble périphérique 403P uniquement.

De manière analogue à ce qui a été précédemment décrit en relation avec la figure 4E, la gravure isotrope conduit, dans l'exemple représenté, à la formation de la région 407 partiellement sphérique au fond de chaque via 101 de l'ensemble périphérique 403P. Dans l'exemple illustré, les régions 407 sont sensiblement situées à une même profondeur dans le substrat semiconducteur 103.

Bien que cela n'ait pas été détaillé, des étapes ultérieures analogues ou identiques à celles précédemment décrites en relation avec les figures 4F à 4J sont par exemple mises en œuvre à partir de la structure de la figure 5B. La mise en œuvre de ces étapes conduit à l'obtention d'un filtre à ondes acoustiques de volume présentant une structure analogue à celle du filtre 400 décrit ci-dessus en relation avec la figure 4J.

Parmi ces étapes, une étape de recuit sous hydrogène analogue ou identique à celle décrite ci-dessus en relation avec la figure 4F conduit en particulier à la formation, dans le substrat semiconducteur 103, de cavités analogues aux cavités 105C, 105P et 405 de la structure de la figure 4F.

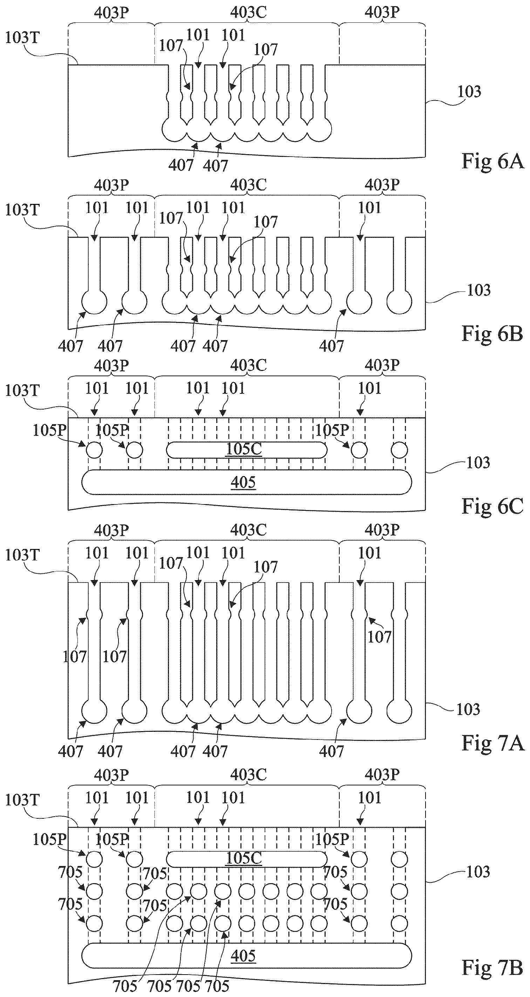

La figure 6A, la figure 6B et la figure 6C illustrent, par des vues de côté et en coupe, schématiques et partielles, des étapes successives d'une variante du procédé des figures 4A à 4J.

La figure 6A est une vue de côté et en coupe, schématique et partielle, illustrant une étape de formation des vias 101 faisant partie de l'ensemble central 403C uniquement.

Les vias 101 de l'ensemble central 403C sont par exemple formés de manière analogue ou identique à ce qui a été décrit précédemment en relation avec les figures 4A et 4B. À titre d'exemple, le fond de chaque via 101 de l'ensemble central 403C de la structure de la figure 6A est situé à la profondeur D1.

La figure 6A illustre en outre une étape ultérieure de gravure anisotrope des vias 101 de l'ensemble central 403C, suivie d'étapes de gravure isotrope puis de gravure anisotrope de ces vias, par exemple de manière analogue ou identique à ce qui a été décrit ci-dessus en relation avec les figures 4D et 4E.

La structure illustrée en figure 6A diffère par exemple de celle de la figure 4E en ce qu'elle est dépourvue des vias 101 faisant partie de l'ensemble périphérique 403P.

La figure 6B est une vue de côté et en coupe, schématique et partielle, illustrant une étape ultérieure de formation des vias 101 faisant partie de l'ensemble périphérique 403P suivie d'une étape de gravure isotrope de ces vias, par exemple de manière analogue ou identique à ce qui a été décrit ci-dessus en relation avec les figures 5A et 5B pour les vias 101 faisant partie de l'ensemble périphérique 403P.

La figure 6C est une vue de côté et en coupe, schématique et partielle, illustrant une étape ultérieure de recuit du substrat semiconducteur 103. L'étape de recuit est par exemple mise en œuvre de façon analogue ou identique à ce qui a été décrit ci-dessus en relation avec la figure 4F.

Dans l'exemple illustré, le recuit conduit à l'obtention, à partir des régions 107 des vias de l'ensemble central 403C, de la cavité 105C et, à partir des régions 107 des vias 101 faisant partie de l'ensemble périphérique 403P, de plusieurs cavités 105P disjointes. En outre, dans cet exemple, le recuit conduit à l'obtention, à partir des régions 407 des vias 101 de l'ensemble périphérique 403P et à partir des régions 407 des vias 101 de l'ensemble central 403C, de la cavité 405. Dans cet exemple, les cavités 105P sont situées à une profondeur différente de celle de la cavité 105C (une profondeur strictement inférieure à celle de la cavité 105C, dans l'exemple illustré). Cela provient du fait qu'à la différence de la cavité 105C, la profondeur des cavités 105P n'a pas été fixée par une étape préalable de gravure isotrope conformément à ce qui a été exposé précédemment en relation avec les figures 1 à 3.

Bien que cela n'ait pas été détaillé, des étapes ultérieures analogues ou identiques à celles précédemment décrites en relation avec les figures 4G à 4J sont par exemple mises en œuvre à partir de la structure de la figure 6C. La mise en œuvre de ces étapes conduit à l'obtention d'un filtre à ondes acoustiques de volume présentant une structure analogue à celle du filtre 400 décrit ci-dessus en relation avec la figure 4J.

La figure 7A et la figure 7B illustrent, par des vues de côté et en coupe, schématiques et partielles, des étapes successives d'une variante du procédé des figures 4A à 4J.

La figure 7A est une vue de côté et en coupe, schématique et partielle, illustrant une étape de formation d'une pluralité de vias 101 dans le substrat semiconducteur 103, par exemple de manière analogue ou identique à ce qui a été décrit ci-dessus en relation avec les figures 4A et 4B, puis de gravure isotrope des vias 101, par exemple de manière analogue ou identique à ce qui a été décrit ci-dessus en relation avec la figure 4C. Cela conduit à la formation de la région 107 partiellement sphérique au fond de chaque via 101.

La figure 7A illustre en outre une étape ultérieure de gravure anisotrope des vias 101. Cette étape diffère par exemple de celle précédemment décrite en relation avec la figure 4D en ce qu'elle est mise en œuvre pendant une durée plus longue. À l'issue de cette étape, chaque via 101 présente une profondeur strictement supérieure à la profondeur D1, par exemple supérieure à la profondeur D3. À titre d'exemple, chaque via présente une profondeur permettant, après recuit, de former quatre cavités à partir de chaque via 101.

La figure 7A illustre en outre une étape ultérieure de gravure isotrope des vias 101, par exemple de manière analogue ou identique à ce qui a été décrit ci-dessus en relation avec la figure 4E. La gravure isotrope conduit, dans l'exemple représenté, à la formation de la région 407 partiellement sphérique au fond de chaque via 101.

La figure 7B est une vue de côté et en coupe, schématique et partielle, illustrant une étape de recuit du substrat semiconducteur 103. L'étape de recuit est par exemple mise en œuvre de façon analogue à ce qui a été décrit ci-dessus en relation avec la figure 4F.

Dans l'exemple illustré, le recuit conduit à l'obtention, à partir des régions 107 des vias 101 faisant partie de l'ensemble central 403C, de l'unique cavité 105C et, à partir des régions 107 des vias 101 faisant partie de l'ensemble périphérique 403P, des cavités 105P disjointes. En outre, dans cet exemple, le recuit conduit à l'obtention, à partir des régions 407, de l'unique cavité 405. La cavité 405 est plus précisément formée à partir des régions 407 des vias 101 faisant partie de l'ensemble central 403C et à partir des régions 407 des vias 101 faisant partie de l'ensemble périphérique 403P. Dans l'exemple représenté, le recuit conduit en outre à l'obtention, pour chacun des vias 101, de deux cavités 705 sensiblement alignées verticalement et interposées entre la cavité 405 et la cavité 105C, pour les cavités 705 issues des vias 101 de l'ensemble central 403C, et entre la cavité 405 et la cavité 105P sus-jacente, pour les cavités 705 issues des vias 101 de l'ensemble périphérique 403P.

Chacune des cavités 705 est par exemple une cavité d'air enterrée, ou enfouie, dans le substrat semiconducteur 103 et disjointe des autres cavités 705, 105C, 105P, 405. Chaque cavité 705 est ainsi intégralement contenue dans le substrat semiconducteur 103, chaque cavité 705 étant totalement close.

Bien que cela n'ait pas été détaillé, des étapes ultérieures analogues ou identiques à celles précédemment décrites en relation avec les figures 4G à 4J sont par exemple mises en œuvre à partir de la structure de la figure 7B. La mise en œuvre de ces étapes conduit à l'obtention d'un filtre à ondes acoustiques de volume présentant une structure analogue à celle du filtre 400 décrit ci-dessus en relation avec la figure 4J. La variante des figures 7A et 7B permet par exemple de conserver, à l'issue d'une étape analogue à celle précédemment décrite en relation avec la figure 4I, une épaisseur de substrat semiconducteur 103 supérieure à celle qui est obtenue par la mise en œuvre des procédés décrits ci-dessus en relation avec les figures 4A à 6C.

Par ailleurs, bien que les figures 7A et 7B prennent pour exemple un cas dans lequel chaque via 101 conduit, après recuit, à l'obtention de deux cavités 705 superposées, cet exemple n'est pas limitatif et la personne du métier est plus généralement capable, à partir des indications de la présente description, de prévoir de réaliser un nombre entier non nul de cavités 705 à partir de chaque via 101, notamment en fonction de l'épaisseur cible de substrat semiconducteur 103 qu'elle souhaite obtenir à l'issue d'une étape analogue à celle précédemment décrite en relation avec la figure 4I.

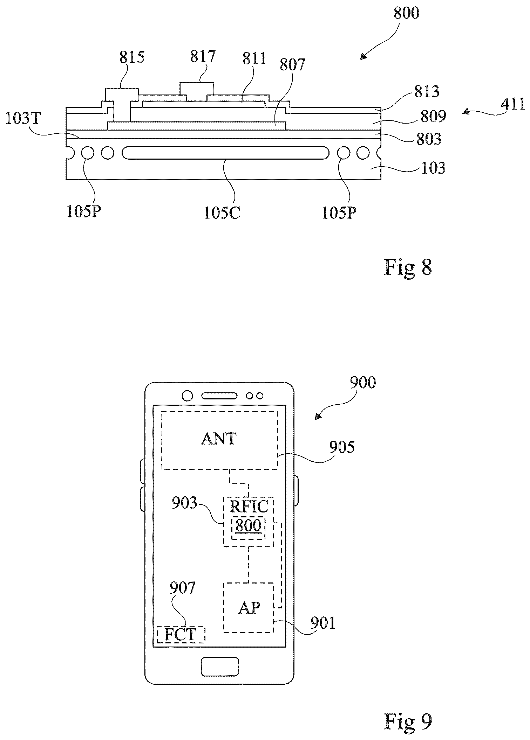

La figure 8 est une vue de côté et en coupe, schématique et partielle, d'un exemple de filtre 800 à ondes acoustiques de volume selon un mode de réalisation.

Dans l'exemple illustré, le filtre 800 présente une structure analogue à celle de l'une des puces semiconductrices 421 de la figure 4I mais dépourvue du capot 413 de protection et des piliers 415 conducteurs. Dans cet exemple, le filtre 800 comprend le résonateur 411.

Dans l'exemple représenté, le filtre 800 comprend une couche isolante 803 revêtant la face supérieure 103T du substrat semiconducteur 103. Dans l'exemple illustré, la couche isolante 803 est située sur et en contact avec toute la face supérieure 103T du substrat semiconducteur 103. La couche isolante 803 présente par exemple une épaisseur comprise entre 1,3 et 4 µm. À titre d'exemple, la couche isolante 803 est en un oxyde, par exemple l'oxyde de silicium. La couche isolante 803 fait par exemple office de couche de passivation de la face supérieure 103T du substrat semiconducteur 103.

Dans l'exemple représenté, le filtre 800 comprend en outre une électrode 807 revêtant une partie de la face supérieure de la couche isolante 803. Dans l'exemple illustré, l'électrode 807 est située sur et en contact avec une partie de la face supérieure de la couche isolante 803. L'électrode 807 est au moins partiellement située à l'aplomb de la cavité 105C. Comme dans l'exemple illustré en figure 8, l'électrode 807 est par exemple majoritairement située à l'aplomb de la cavité 105C. Dans cet exemple, l'électrode 807 comprend en outre une partie minoritaire s'étendant latéralement hors de l'aplomb de la cavité 105C. À titre d'exemple, l'électrode 807 est en un matériau conducteur, par exemple un métal tel que l'aluminium ou un alliage métallique.

Dans l'exemple illustré, le filtre 800 comprend en outre une autre couche isolante 809 revêtant les faces latérales et la face supérieure de l'électrode 807. Dans cet exemple, la couche isolante 809 revêt en outre des parties de la face supérieure de la couche isolante 803 non revêtues de l'électrode 807. Dit autrement, la couche isolante 809 s'étend latéralement hors de l'aplomb de l'électrode 807. La couche isolante 809 est par exemple plus précisément située sur et en contact avec les faces latérales et supérieure de l'électrode 807 et avec les parties de la face supérieure de la couche isolante 803 non revêtues de l'électrode 807. À titre d'exemple, la couche isolante 809 est une couche piézoélectrique, c'est-à-dire une couche en un matériau piézoélectrique, par exemple le niobate de lithium (« Lithium Niobate Oxide » - LNO, en anglais), le nitrure d'aluminium, etc.

Dans l'exemple représenté, le filtre 800 comprend en outre une autre électrode 811 revêtant une partie de la face supérieure de la couche isolante 809. Dans l'exemple illustré, l'électrode 811 est située sur et en contact avec une partie de la face supérieure de la couche isolante 809. L'électrode 811 est par exemple au moins partiellement située à l'aplomb de la cavité 105C. Comme dans l'exemple illustré en figure 8, l'électrode 811 est par exemple totalement située à l'aplomb de la cavité 105C. Dans cet exemple, l'électrode 811 présente des dimensions latérales strictement inférieures à celles de l'électrode 807. À titre d'exemple, l'électrode 811 est en un matériau conducteur, par exemple un métal tel que l'aluminium ou un alliage métallique. L'électrode 811 est par exemple en le même matériau que l'électrode 807.

L'électrode 811 présente par exemple, en vue de dessus, une forme asymétrique.

Dans l'exemple illustré, le filtre 800 comprend en outre encore une autre couche isolante 813 revêtant les faces latérales et la face supérieure de l'électrode 811. Dans cet exemple, la couche isolante 813 revêt en outre des parties de la face supérieure de la couche isolante 809 non revêtues de l'électrode 811. La couche isolante 813 est par exemple plus précisément située sur et en contact avec les faces latérales et supérieure de l'électrode 811 et avec les parties de la face supérieure de la couche isolante 809 non revêtues de l'électrode 811. À titre d'exemple, la couche isolante 813 est en un oxyde, par exemple l'oxyde de silicium. La couche isolante 813 est par exemple en le même matériau que la couche isolante 803. La couche isolante 813 fait par exemple office de couche de passivation de la face supérieure de la structure, notamment de l'électrode 811.

Dans l'exemple représenté, le filtre 800 comprend en outre des éléments de reprise de contact 815 et 817 des électrodes 807 et 811, respectivement. Dans l'exemple illustré en figure 8, l'élément de reprise de contact 815 est situé sur et en contact avec une partie de la face supérieure de l'électrode 807 située hors de l'aplomb de la cavité 105C. L'élément de reprise de contact 815 présente par exemple, en vue en coupe, une forme de T comprenant une partie verticale s'étendant, depuis la face supérieure de la couche isolante 813, à travers les couches isolantes 813 et 809 jusqu'à la face supérieure de l'électrode 807 et une partie horizontale s'étendant latéralement sur et en contact avec la face supérieure de la couche isolante 813 au voisinage de la partie verticale de l'élément de reprise de contact 815.

Par ailleurs, dans cet exemple, l'élément de reprise de contact 817 est situé sur et en contact avec une partie de la face supérieure de l'électrode 811 située à l'aplomb de la cavité 105C. L'élément de reprise de contact 817 présente par exemple, en vue en coupe, une forme de T comprenant une partie verticale s'étendant, depuis la face supérieure de la couche isolante 813, à travers la couche isolante 813 jusqu'à la face supérieure de l'électrode 811 et une partie horizontale s'étendant latéralement sur et en contact avec la face supérieure de la couche isolante 813 au voisinage de la partie verticale de l'élément de reprise de contact 817. Chaque élément de reprise de contact 815, 817 est en un matériau conducteur, par exemple un métal ou un alliage métallique. À titre d'exemple, les éléments de reprise de contact 815 et 817 sont en le même matériau.

Bien que cela n'ait pas été illustré en figure 8 afin de ne pas surcharger le dessin, les éléments de reprise de contact 815 et 817 sont par exemple destinés à être reliés ou connectés à un ou plusieurs composants ou circuits extérieurs au filtre 800. À titre d'exemple, les éléments de reprise de contact 815 et 817 sont destinés à être connectés à un circuit de communication radiofréquence d'un dispositif électronique.

Les électrodes 807 et 811 et la partie de la couche isolante 809 interposée entre les électrodes 807 et 811 font par exemple partie du résonateur 411 du filtre 800. La couche isolante 809 est par exemple appelée couche active du résonateur 411 du filtre 800, en raison du fait que la couche isolante 809 est destinée à être excitée par un signal appliqué sur les électrodes 807 et 811 disposées de part et d'autre de cette couche.

En fonctionnement, un signal radiofréquence est par exemple appliqué, par les éléments de reprise de contact 815 et 817, entre les électrodes 807 et 811 du filtre 800. Le signal radiofréquence est par exemple une tension alternative. L'application, sur les électrodes 807 et 811, du signal radiofréquence provoque par exemple une alternance de phases d'expansion et de contraction de la couche isolante 809. Cela tend à faire résonner le résonateur 411 du filtre 800 et à faire vibrer la membrane du filtre 800. Dans un cas où le signal radiofréquence présente une fréquence sensiblement égale à une fréquence de résonance de la membrane du filtre 800, le signal radiofréquence n'est pas, ou est peu, atténué par le filtre 800. En revanche, dans un cas où le signal radiofréquence présente une fréquence différente de la fréquence de résonance de la membrane du filtre 800, le signal radiofréquence est fortement atténué par le filtre 800. Cela permet par exemple d'éviter que le fonctionnement d'un canal de réception de communications radiofréquence d'un dispositif électronique ne soit perturbé par des interférences causées par des signaux radiofréquence émis par d'autres dispositifs électroniques, ou par du bruit provenant de sources radiofréquence externes.

La figure 9 illustre, de façon schématique et partielle, un exemple de dispositif électronique 900 intégrant un filtre à ondes acoustiques de volume, par exemple le filtre 800 précédemment décrit en relation avec la figure 8. Dans l'exemple représenté, le dispositif 900 est un téléphone mobile, ou smartphone.

Dans cet exemple, le dispositif 900 comprend un circuit de traitement 901 (AP), par exemple un microcontrôleur ou un microprocesseur principal du dispositif 900. Le circuit de traitement 901 est par exemple connecté à un circuit intégré radiofréquence 903 (RFIC) comprenant au moins un filtre du type du filtre 400 ou 800, par exemple un filtre 800. Le filtre 800 est par exemple intégré dans un circuit électronique de filtrage, non détaillé en figure 9. Dans l'exemple illustré, le circuit intégré radiofréquence 903 est connecté à une antenne 905 (ANT), par exemple une antenne de communication radiofréquence du dispositif 900. Bien que cela n'ait pas été détaillé en figure 9 afin de ne pas surcharger le dessin, le circuit intégré radiofréquence 903 peut en outre comprendre des composants et circuits destinés à mettre en œuvre des fonctions d'adaptation d'impédance, d'amplification, de modulation/démodulation, de commutation, etc.

Le dispositif 900 peut en outre comprendre d'autres éléments, par exemple d'autres composants électroniques ou circuits non détaillés en figure 9. Ces éléments ont été symbolisés, en figure 9, par un bloc fonctionnel 907 (FCT).

Bien que la figure 9 illustre un cas dans lequel le filtre 800 est intégré dans le dispositif 900, cet exemple n'est pas limitatif et la personne du métier est capable de prévoir, à partir des indications de la présente description, de substituer, dans le dispositif 900, le filtre 800 par le filtre 400 ou par un filtre présentant une structure analogue à celle du filtre 400 ou 800.

Les filtres 400 et 800 ont pour avantage de comporter un substrat 103 de faible épaisseur, par exemple une épaisseur au moins deux fois inférieure à celle qui peut être atteinte en utilisant des techniques usuelles de meulage ou de polissage mécano-chimique depuis la face arrière 103B du substrat 103. Cela permet de miniaturiser les filtres 400 et 800. À titre d'exemple, le substrat 103 des filtres 400 et 800 présente une épaisseur inférieure à 50 µm, par exemple inférieure à 25 µm, par exemple inférieure à 10 µm.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que les figures 4J et 8 prennent pour exemple un cas dans lequel le filtre 400, 800 comprend un seul résonateur 411 situé au-dessus de la cavité 105C, la personne du métier est bien entendu capable, à partir des indications de la présente description, de transposer les modes de réalisation des figures 4J et 8 à un nombre quelconque de résonateurs situés au-dessus d'une même cavité réalisée dans un substrat semiconducteur.

À partir des indications de la présente description, la personne du métier est en outre capable de réaliser plusieurs filtres dans un même substrat semiconducteur, par exemple en prévoyant de former plusieurs cavités enterrées dans un même substrat semiconducteur et au moins un résonateur situé à l'aplomb de chaque cavité.

Par ailleurs, bien que la figure 9 prenne pour exemple le cas d'une intégration du filtre 400 dans un téléphone mobile ou un smartphone, les modes de réalisation décrits ne se limitent pas à cet exemple mais s'appliquent plus généralement à tout dispositif ou système doté de fonctions de communication sans fil, par exemple dans le domaine de la télématique. En particulier, le filtre 400 ou le filtre 800 peut être intégré dans des véhicules automobiles, par exemple pour mettre en œuvre des fonctionnalités d'accès à Internet sans fil, de communication du véhicule avec des équipements ou systèmes extérieurs, de conduite autonome, etc. pour des applications finales telles que la gestion de flottes de véhicules (emplacement, mouvement, état et comportement de chaque véhicule) ou les systèmes de navigation en temps réel, ou encore pour permettre à des objets de communiquer avec un véhicule (par exemple dans le cadre de l'internet des objets - IoT), le tout sans interférences par des systèmes non acceptés dans un « cercle » de communication autorisé.

Enfin, la mise en œuvre pratique des modes de réalisation et variantes décrits est à la portée de la personne du métier à partir des indications fonctionnelles données ci-dessus. En particulier, la réalisation du filtre 800 est à la portée de la personne du métier à la lecture de la présente description, notamment à partir du procédé de fabrication du filtre 400 décrit en relation avec les figures 4A à 4J.

Par ailleurs, les modes de réalisation décrits ne se limitent pas aux exemples particuliers de matériaux et de dimensions mentionnés dans la présente description.

## Revendications

1. Procédé de fabrication d'un filtre (400 ; 800) à ondes acoustiques de volume comprenant les étapes successives suivantes :
a) prévoir un substrat semiconducteur (103) ;
b) former des première (105C) et deuxième (405) cavités d'air enterrées dans le substrat semiconducteur (103), la première cavité d'air (105C) étant interposée entre la deuxième cavité d'air (405) et une face supérieure (103T) du substrat semiconducteur (103) et présentant des dimensions latérales inférieures à celles de la deuxième cavité d'air (405) ; et
c) amincir le substrat semiconducteur (103) par formation de tranchées (419) entourant la première cavité d'air (105C) et débouchant dans la deuxième cavité d'air (405).

2. Procédé selon la revendication 1, comprenant en outre, entre les étapes a) et b), une étape de formation, dans le substrat semiconducteur (103), d'un premier ensemble (403C) de premiers vias (101) et d'un deuxième ensemble (403P) de deuxièmes vias (101) entourant le premier ensemble (403C) de premiers vias (101).

3. Procédé selon la revendication 2, dans lequel, à l'étape b), la première cavité d'air (105C) est formée à partir des premiers vias (101) et la deuxième cavité d'air (405) est formée à partir des premiers et deuxièmes vias (101).

4. Procédé selon la revendication 2 ou 3, comprenant, entre les étapes a) et b), les opérations suivantes :
- former les premiers et deuxièmes vias (101) par gravure anisotrope du substrat semiconducteur (103) ;
- former une première région (107) partiellement sphérique au fond de chaque via (101) par gravure isotrope du substrat semiconducteur (103) ;
- prolonger les premiers et deuxièmes vias (101) par gravure anisotrope du substrat semiconducteur (103) ; et
- former une deuxième région (407) partiellement sphérique au fond de chaque via (101) par gravure isotrope du substrat semiconducteur (103).

5. Procédé selon la revendication 2 ou 3, comprenant, entre les étapes a) et b), les opérations suivantes :
- former les premiers et deuxièmes vias (101) par gravure anisotrope du substrat semiconducteur (103) ; et
- former une région (407) partiellement sphérique au fond de chaque deuxième via (101) par gravure isotrope du substrat semiconducteur (103).

6. Procédé selon la revendication 2 ou 3, comprenant, entre les étapes a) et b), les opérations suivantes :
- former les premiers vias (101) par gravure anisotrope du substrat semiconducteur (103) ;
- former une première région (107) partiellement sphérique au fond de chaque premier via (101) par gravure isotrope du substrat semiconducteur (103) ;
- prolonger les premiers vias (101) par gravure anisotrope du substrat semiconducteur (103) ;
- former une deuxième région (407) partiellement sphérique au fond de chaque premier via (101) par gravure isotrope du substrat semiconducteur (103) ;
- former les deuxièmes vias (101) par gravure anisotrope du substrat semiconducteur (103) ; et
- former une troisième région (407) partiellement sphérique au fond de chaque deuxième via (101) par gravure isotrope du substrat semiconducteur (103).

7. Procédé selon l'une quelconque des revendications 1 à 6, comprenant en outre, à l'étape b), la formation, à partir de chacun des premier et deuxième vias (101), d'au moins une troisième cavité d'air (705) interposée entre les première (105C) et deuxième (405) cavités d'air.

8. Procédé selon l'une quelconque des revendications 1 à 7, comprenant en outre, à l'étape b), la formation, à partir de chaque deuxième via (101), d'au moins une quatrième cavité d'air (105P) située, dans le substrat semiconducteur (103), à une profondeur sensiblement égale à celle de la première cavité d'air (105C).

9. Procédé selon l'une quelconque des revendications 1 à 8, comprenant en outre, entre les étapes b) et c), une étape de réalisation d'au moins un résonateur (411) à l'aplomb de la première cavité d'air (105C), chaque résonateur (411) comprenant une couche active (809) interposée entre une électrode inférieure (807) et une électrode supérieure (811).

10. Procédé selon l'une quelconque des revendications 1 à 9, dans lequel, à l'étape b), la première cavité d'air (105C) et la deuxième cavité d'air (405) sont formées par recuit du substrat semiconducteur (103) sous atmosphère d'hydrogène.

11. Filtre (400 ; 800) à ondes acoustiques de volume obtenu par le procédé selon l'une quelconque des revendications 1 à 10.

12. Filtre (400 ; 800) selon la revendication 11, dans lequel la première cavité d'air (105C) est située, dans le substrat semiconducteur (103), à une profondeur comprise entre 300 nm et 1,5 µm.

13. Filtre (400 ; 800) selon la revendication 11 ou 12, dans lequel le substrat semiconducteur (103) présente, après amincissement, une épaisseur inférieure à 50 µm, de préférence inférieure à 25 µm, plus préférentiellement inférieure à 10 µm.

14. Dispositif électronique (900), de préférence téléphone mobile ou smartphone, comprenant un circuit intégré radiofréquence (903) comportant au moins un filtre (400 ; 800) selon l'une quelconque des revendications 11 à 13.
